# EUROPÄISCHE PATENTANMELDUNG

(11) **EP 2 368 934 A1**
(43) Veröffentlichungstag der Anmeldung: **28.09.2011**
(21) Anmeldenummer: 10003274.7
(22) Anmeldetag: 26.03.2010
(51) Int. Cl.: C08J 7/04, C09D 5/24, C09D 175/04, C08G 18/28, C08G 18/38, H01B 1/12, H01L 51/00

(54) **Polymerschichtenverbund mit verbesserter Haftung der Schichten**

(71) Anmelder: Bayer MaterialScience AG, 51368 Leverkusen (DE)
(72) Erfinder: Die Erfindernennung liegt noch nicht vor

(57) **Zusammenfassung**

Ein Polymerschichtenverbund umfasst eine erste Schicht und eine die erste Schicht zumindest teilweise kontaktierende zweite Schicht. Die erste Schicht ein umfasst Polyurethanpolymer, welches erhältlich ist aus der Reaktion eines Polyisocyanats A) und/oder eines Polyisocyanat-Prepolymers B) mit einer mindestens difunktionellen, gegenüber Isocyanatgruppen reaktiven Verbindung C) sowie weiterhin eines monomeren, monofunktionellen aromatischen Alkohols. Die zweite Schicht umfasst polymeres in 3- und/oder 4-Position substituiertes Thiophen der allgemeinen Formel und Polystyrolsulfonat. Vorzugsweise wird für die erste Schicht 2-Hydroxymethyl-3,4-ethylendioxythiophen und für die zweite Schicht Poly(3,4-ethylendioxythiophen) eingesetzt. Die Erfindung betrifft weiterhin ein Verfahren zur Herstellung eines solchen Schichtenverbundes sowie einen diesen Schichtenverbund aufweisenden elektromechanischen Wandler.

## Beschreibung

Die vorliegende Erfindung betrifft einen Polymerschichtenverbund, umfassend eine erste Schicht und eine die erste Schicht zumindest teilweise kontaktierende zweite Schicht, wobei die erste Schicht ein Polyurethanpolymer umfasst und die zweite Schicht Thiophenpolymere und Polystyrolsulfonat umfasst. Die Erfindung betrifft weiterhin ein Verfahren zur Herstellung eines solchen Schichtverbundes und einen elektromechanischen Wandler, welcher einen solchen Schichtenverbund umfasst.

Zur Herstellung von dielektrischen elastomeren Aktoren wird üblicherweise eine Folie eines dielektrischen Elastomers, welches ein Isolator ist, beidseitig mit Elektroden versehen. Das dielektrische Elastomer kann beispielsweise Polyurethan sein. Hierbei ist es günstig, wenn die Elektroden in Form einer Beschichtung auf dem Elastomer aufgetragen werden. Dieses bedingt gewisse Eigenschaften des Elektrodenmaterials, insbesondere eine ausreichende Elastizität, ohne die elektrische Leitfähigkeit zu verlieren und weiterhin die Möglichkeit, die Elektrode als Schicht auftragen zu können.

Dehnbare elektrisch leitfähige Materialien auf der Basis von Poly(ethylendioxythiophen) (PEDOT) und Polyurethanelastomeren werden beispielsweise in der Veröffentlichung von N. B. Larsen et al., Adv. Funct. Mater. 2007, 17, 3069-3073 beschrieben. Hierbei wird jedoch ein Polymerblend aus PEDOT:p-Tosylat und einem aliphatischen Polyurethanelastomer verwendet. Zur Herstellung wird EDOT in einer Lösung des Polyurethans in Tetrahydrofuran polymerisiert. Anschließend wird die Zusammensetzung auf ein Substrat aufgetragen und das Lösungsmittel wird verdampft. Nachteilig an diesem Verfahren ist insbesondere aus Kostengesichtspunkten, dass ein Polyurethanpolymer als Matrix verwendet werden muss. Weiterhin könnten die benötigten Lösungsmittel, in diesem Fall Tetrahydrofuran, nicht mit allen Substratoberflächen kompatibel sein.

Ein in WO 2008/064878 vorgeschlagenes Verfahren betrifft ein Verfahren zur Herstellung eines elektrochromen Materials auf der Basis von hydroxymethylsubstituiertem EDOT oder Hydroxypropylendioxythiophen. Hervorgehoben wird hierbei die Adhäsion zu Substraten. Allerdings ist eine umfangreiche Folgechemie nötig, um geeignete Oberflächen mit dem gewünschten Material zu beschichten.

Polymerblends aus Polystrolsulfonat (PSS) und PEDOT werden häufig als elektrisch leitfähige Polymere eingesetzt. Eines der größten Hindernisse in ihrem praktischen Einsatz ist jedoch deren schlechte Haftung auf vielen Substraten. In Hinblick auf kontaktierte dielektrische Elastomere betrifft dieses insbesondere die Delaminierung einer PSS:PEDOT-Schicht von der Elastomerschicht während des Auslenkens des Elastomers.

Wünschenswert wäre folglich die Möglichkeit, die Haftung PSS:PEDOT-Schichten auf Polyurethansubstraten zu verbessern.

Erfindungsgemäß vorgeschlagen wird daher ein Polymerschichtenverbund, umfassend eine erste Schicht und eine die erste Schicht zumindest teilweise kontaktierende zweite Schicht, wobei die die erste Schicht ein Polyurethanpolymer umfasst, welches erhältlich ist aus der Reaktion eines Polyisocyanats A) und/oder eines Polyisocyanat-Prepolymers B) mit einer mindestens difunktionellen, gegenüber Isocyanatgruppen reaktiven Verbindung C) sowie weiterhin eines monomeren, monofunktionellen aromatischen Alkohols; und
die zweite Schicht polymeres in 3- und/oder 4-Position substituiertes Thiophen der allgemeinen Formel (I): 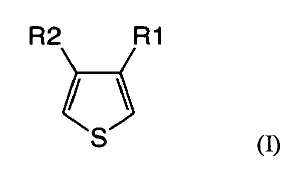 wobei gilt: R1 und R2 sind unabhängig voneinander Wasserstoff, Alkyl, Aryl, Alkoxy, Aryloxy oder aber R1 und R2 bilden gemeinsam eine unsubstituierte oder substituierte Alkylendioxy-Gruppe
und Polystyrolsulfonat umfasst.

Es wird angenommen, dass der monomere, monofunktionelle aromatische Alkohol während der Polyurethanherstellung mit Isocyanatgruppen reagiert und so kovalent in das Polymer eingebunden wird. Es wurde gefunden, dass dieses zu einer verbesserten Haftung der zweiten Schicht führt. Ohne auf eine Theorie beschränkt zu sein, werden hierfür attraktive Wechselwirkungen zwischen den π-Elektronensystemen der Komponenten angenommen. Dieses lässt sich auch mit dem Begriff "π-π-Stapelung" umschreiben. Es lassen sich dehnbare Elektroden konstruieren, die in größeren Dehnungsbereichen betrieben werden können.

Geeignete monomere, monofunktionelle aromatische Alkohole sind carbo- oder heterozyklische Aromaten wie Benzylalkohol, Thiophene, Furane und/oder Pyrrole. Vorzugsweise ist die OH-Gruppe über eine oder mehrere Methylengruppen an den aromatischen Kern gebunden. Auf diese Weise lässt sich der aromatische Ring für die gewünschte π-π-Stapelung leichter ausrichten.

Eine geeignete Form des Polystyrolsulfonats ist insbesondere das Natriumpolystyrolsulfonat.

Der Begriff "Alkyl" umfasst allgemein im Zusammenhang der gesamten Erfindung Substituenten aus der Gruppe n-Alkyl wie Methyl, Ethyl oder Propyl, verzweigtes Alkyl und/oder Cycloalkyl. Der Begriff "Aryl" umfasst allgemein im Zusammenhang der gesamten Erfindung Substituenten aus der Gruppe einkernige Carbo- oder Heteroarylsubstituenten wie Phenyl und/oder mehrkernige Carbo- oder Heteroarylsubstituenten. Analoges gilt für die Begriffe "Alkoxy" und "Aryloxy".

Beispiele für unsubstituierte Alkylendioxy-Gruppen -O-[CH₂]ₙ-O- sind Methylendioxy (-O-[CH₂]-O-), Ethylendioxy (-O-[Ch₂]₂-O-), Propylendioxy (-O-[Ch₂]₃-O-) und Butylendioxy (-O-[CH₂]₄-O-). In substituierten Alkylendioxy-Gruppen befinden sich an den [CH₂]ₙ-Gruppen weitere Substituenten. Beispielsweise kann jedes Kohlenstoffatom einer Ethylendioxy-Gruppe einen Methylsubstituenten tragen (-O-[CH(CH₃)₂]₂-O-). Weitere Substituenten für Alkylendioxygruppen können unter anderem Hydroxy- und Hydroxymethylgruppen sein.

Als Polyisocyanat und Komponente A) eignen sich beispielsweise 1,4-Butylendiisocyanat, 1,6 Hexamethylendiisocyanat (HDI), Isophorondiisocyanat (IPDI), 2,2,4 und/oder 2,4,4-Trimethylhexamethylendiisocyanat, die isomeren Bis-(4,4'-isocyanatocyclohexyl)methane oder deren Mischungen beliebigen Isomerengehalts, 1,4-Cyclohexylendiisocyanat, 4-Isocyanatomethyl-1,8-octandiisocyanat (Nonantriisocyanat), 1,4-Phenylendiisocyanat, 2,4- und/oder 2,6-Toluylendiisocyanat, 1,5-Naphthylendiisocyanat, 2,2'- und/oder 2,4'- und/oder 4,4'-Diphenylmethandiisocyanat, 1,3- und/oder 1,4-Bis-(2-isocyanato-prop-2-yl)-benzol (TMXDI), 1,3-Bis(isocyanatomethyl)benzol (XDI), Alkyl-2,6-diisocyanatohexanoate (Lysindiisocyanate) mit Alkylgruppen mit 1 bis 8 Kohlenstoffatomen sowie Mischungen davon. Weiterhin sind Uretdion-, Isocyanurat-, Biuret-, Iminooxadiazindion- oder Oxadiazintrionstruktur enthaltende Verbindungen basierend auf den genannten Diisocyanaten geeignete Bausteine der Komponente A).

In einer Ausführungsform kann die Komponente A) ein Polyisocyanat oder ein Polyisocyanatgemisch mit einer mittleren NCO-Funktionalität von 2 bis 4 mit ausschließlich aliphatisch oder cycloaliphatisch gebundenen Isocyanatgruppen sein. Bevorzugt handelt es sich um Polyisocyanate oder Polyisocyanatgemische der vorstehend genannten Art mit Uretdion-, Isocyanurat-, Biuret-, Iminooxadiazindion- oder Oxadiazintrionstruktur sowie Mischungen daraus und einer mittleren NCO-Funktionalität der Mischung von 2 bis 4, bevorzugt von 2 bis 2,6 und besonders bevorzugt von 2 bis 2,4.

Besonders bevorzugt können als Komponente A) Polyisocyanate auf der Basis von Hexamethylendiisocyanat, Isophorondiisocyanat oder die isomeren Bis-(4,4'-isocyanatocyclohexyl)methane sowie Mischungen der vorgenannten Diisocyanate eingesetzt werden.

Die als Komponente B) einsetzbaren Polyisocyanat-Prepolymere können durch Umsetzung von einem oder mehreren Diisocyanaten mit einem oder mehreren hydroxyfunktionellen, insbesondere polymeren, Polyolen gegebenenfalls unter Zusatz von Katalysatoren sowie Hilfs- und Zusatzstoffen erhalten werden. Des Weiteren können zusätzlich Komponenten zur Kettenverlängerung, wie beispielsweise mit primären und/oder sekundären Aminogruppen (NH₂-und/oder NH-funktionelle Komponenten) für die Bildung des Polyisocyanat-Prepolymers eingesetzt werden.

Das Polyisocyanat-Prepolymer als Komponente B) kann bevorzugt aus der Umsetzung von polymeren Polyolen und aliphatischen Diisocyanaten erhältlich sein. Bevorzugt sind dabei als Komponente B) Polyisocyanat-Prepolymere auf Basis von Polypropylenglykol als Polyol und Hexamethylendiisocyanat als aliphatischem Diisocyanat.

Hydroxyfunktionelle, polymere Polyole für die Umsetzung zum Polyisocyanat-Prepolymer B) können beispielsweise auch Polyesterpolyole, Polyacrylatpolyole, Polyurethanpolyole, Polycarbonatpolyole, Polyetherpolyole, Polyesterpolyacrylatpolyole, Polyurethanpolyacrylatpolyole, Polyurethanpolyesterpolyole, Polyurethanpolyetherpolyole, Polyurethanpolycarbonatpolyole und/oder Polyesterpolycarbonatpolyole sein. Diese können zur Herstellung des Polyisocyanat-Prepolymers einzeln oder in beliebigen Mischungen untereinander eingesetzt werden.

Geeignete Polyesterpolyole zur Herstellung der Polyisocyanat-Prepolymere B) können Polykondensate aus Di- sowie gegebenenfalls Tri- und Tetraolen und Di- sowie gegebenenfalls Tri- und Tetracarbonsäuren oder Hydroxycarbonsäuren oder Lactonen sein. Anstelle der freien Polycarbonsäuren können auch die entsprechenden Polycarbonsäureanhydride oder entsprechende Polycarbonsäureester von niederen Alkoholen zur Herstellung der Polyester verwendet werden.

Beispiele für geeignete Diole sind dabei Ethylenglykol, Butylenglykol, Diethylenglykol, Triethylenglykol, Polyalkylenglykole wie Polyethylenglykol, weiterhin 1,2-Propandiol, 1,3-Propandiol, Butandiol(1,3), Butandiol(1,4), Hexandiol(1,6) und Isomere, Neopentylglykol oder Hydroxypivalinsäureneopentylglykolester oder Mischungen davon, wobei Hexandiol(1,6) und Isomere, Butandiol(1,4), Neopentylglykol und Hydroxypivalinsäureneopentylglykolester bevorzugt sind. Daneben können auch Polyole wie Trimethylolpropan, Glycerin, Erythrit, Pentaerythrit, Trimethylolbenzol oder Trishydroxyethylisocyanurat oder Mischungen davon eingesetzt werden.

Als Dicarbonsäuren können dabei Phthalsäure, Isophthalsäure, Terephthalsäure, Tetrahydrophthalsäure, Hexahydrophthalsäure, Cyclohexandicarbonsäure, Adipinsäure, Azelainsäure, Sebacinsäure, Glutarsäure, Tetrachlorphthalsäure, Maleinsäure, Fumarsäure, Itaconsäure, Malonsäure, Korksäure, 2-Methylbernsteinsäure, 3,3-Diethylglutarsäure und/oder 2,2-Dirmethylbernsteinsäure eingesetzt werden. Als Säurequelle können auch die entsprechenden Anhydride verwendet werden.

Sofern die mittlere Funktionalität des zu veresternden Polyols ≥ 2 ist, können zusätzlich auch Monocarbonsäuren, wie Benzoesäure und Hexancarbonsäure mit verwendet werden.

Bevorzugte Säuren sind aliphatische oder aromatische Säuren der vorstehend genannten Art. Besonders bevorzugt sind dabei Adipinsäure, Isophthalsäure und Phthalsäure.

Hydroxycarbonsäuren, die als Reaktionsteilnehmer bei der Herstellung eines Polyesterpolyols mit endständigen Hydroxylgruppen mitverwendet werden können, sind beispielsweise Hydroxycapronsäure, Hydroxybuttersäure, Hydroxydecansäure oder Hydroxystearinsäure oder Mischungen davon. Geeignete Lactone sind Caprolacton, Butyrolacton oder Homologe oder Mischungen davon. Bevorzugt ist dabei Caprolacton.

Ebenfalls können zur Herstellung der Polyisocyanat-Prepolymere B) Hydroxylgruppen aufweisende Polycarbonate, beispielsweise Polycarbonatpolyole, bevorzugt Polycarbonatdiole, eingesetzt werden. Beispielsweise können diese ein zahlenmittleres Molekulargewichten Mₙ von 400 g/mol bis 8000 g/mol, bevorzugt von 600 g/mol bis 3000 g/mol eingesetzt werden. Diese können durch Reaktion von Kohlensäurederivaten, wie Diphenylcarbonat, Dimethylcarbonat oder Phosgen, mit Polyolen, bevorzugt Diolen, erhalten werden.

Beispiele hierfür geeigneter Diole sind Ethylenglykol, 1,2- und 1,3-Propandiol, 1,3- und 1,4-Butandiol, 1,6-Hexandiol, 1,8-Octandiol, Neopentylglykol, 1,4-Bishydroxymethylcyclohexan, 2-Methyl-1,3-propandiol, 2,2,4-Trimethylpentandiol-1,3, Dipropylenglykol, Polypropylenglykole, Dibutylenglykol, Polybutylenglykole, Bisphenol A oder lactonmodifizierte Diole der vorstehend genannten Art oder Mischungen davon.

Bevorzugt enthält die Diolkomponente dabei von 40 Gewichtsprozent bis 100 Gewichtsprozent Hexandiol, vorzugsweise 1,6-Hexandiol und/oder Hexandiolderivate. Solche Hexandiolderivate basieren auf Hexandiol und können neben endständigen OH-Gruppen Ester- oder Ethergruppen aufweisen. Derartige Derivate sind beispielsweise durch Reaktion von Hexandiol mit überschüssigem Caprolacton oder durch Veretherung von Hexandiol mit sich selbst zum Di- oder Trihexylenglykol erhältlich. Die Menge dieser und anderer Komponenten, werden im Rahmen der vorliegenden Erfindung in bekannter Weise derart gewählt, dass die Summe 100 Gewichtsprozent nicht überschreitet, insbesondere 100 Gewichtsprozent ergibt.

Hydroxylgruppen aufweisende Polycarbonate, insbesondere Polycarbonatpolyole, sind bevorzugt linear gebaut.

Ebenfalls können zur Herstellung der Polyisocyanat-Prepolymere B) Polyetherpolyole eingesetzt werden. Beispielsweise eignen sich Polytetramethylenglykolpolyether wie sie durch Polymerisation von Tetrahydrofuran mittels kationischer Ringöffnung erhältlich sind. Ebenfalls geeignete Polyetherpolyole können die Additionsprodukte von Styroloxid, Ethylenoxid, Propylenoxid, Butylenoxid und/oder Epichlorhydrin an di- oder polyfunktionelle Startermoleküle sein. Als geeignete Startermoleküle können beispielsweise Wasser, Butyldiglykol, Glycerin, Diethylenglykol, Trimethyolpropan, Propylenglykol, Sorbit, Ethylendiamin, Triethanolamin, oder 1,4-Butandiol oder Mischungen davon eingesetzt werden.

Bevorzugte Komponenten zur Herstellung der Polyisocyanat-Prepolymere B) sind Polypropylenglykol, Polytetramethylenglykolpolyether und Polycarbonatpolyole beziehungsweise deren Mischungen, wobei Polypropylenglykol besonders bevorzugt ist.

Dabei können polymere Polyole mit einem zahlenmittleren Molekulargewicht Mₙ von 400 g/mol bis 8000 g/mol, bevorzugt von 400 g/mol bis 6000 g/mol und besonders bevorzugt von 600 g/mol bis 3000 g/mol eingesetzt werden. Diese weisen bevorzugt eine OH-Funktionalität von 1,5 bis 6, besonders bevorzugt von 1,8 bis 3, ganz besonders bevorzugt von 1,9 bis 2,1 auf.

Neben den genannten polymeren Polyolen können auch kurzkettige Polyole bei der Herstellung der Polyisocyanat-Prepolymere B) eingesetzt werden. Beispielsweise kann Ethylenglykol, Diethylenglykol, Triethylenglykol, 1,2-Propandiol, 1,3-Propandiol, 1,4-Butandiol, 1,3-Butylenglykol, Cyclohexandiol, 1,4-Cyclohexandimethanol, 1,6-Hexandiol, Neopentylglykol, Hydrochinondihydroxyethylether, Bisphenol A (2,2-Bis(4-hydroxyphenyl)propan), hydriertes Bisphenol A (2,2-Bis(4-hydroxycyclohexyl)propan), Trimethylolpropan, Trimethylolethan, Glycerin oder Pentaerythrit oder eine Mischung davon eingesetzt werden.

Geeignet sind auch Esterdiole des genannten Molekulargewichtsbereichs wie α-Hydroxybutyl-ε-hydroxy-capronsäureester, ω-Hydroxyhexyl-γ-hydroxybuttersäure-ester, Adipinsäure-(β-hydroxyethyl)ester oder Terephthalsäurebis(β-hydroxyethyl)-ester.

Ferner können zur Herstellung der Polyisocyanat-Prepolymere B) auch monofunktionelle isocyanatreaktive hydroxylgruppenhaltige Verbindungen eingesetzt werden. Beispiele solcher monofunktionellen Verbindungen sind Ethanol, n-Butanol, Ethylenglykolmonobutylether, Diethylenglykolmonomethylether, Diethylenglykolmonobutylether, Propylenglykolmonomethylether, Dipropylenglykol-monomethylether, Tripropylenglykolmonomethylether, Dipropylenglykolmono-propylether, Propylenglykolmonobutylether, Dipropylenglykolmonobutylether, Tripropylenglykolmonobutylether, 2-Ethylhexanol, 1-Octanol, 1-Dodecanol oder 1-Hexadecanol oder Mischungen davon.

Zur Herstellung der Polyisocyanat-Prepolymere B) können vorzugsweise Diisocyanate mit den Polyolen bei einem Verhältnis der Isocyanatgruppen zu Hydroxylgruppen (NCO/OH-Verhältnis) von 2:1 bis 20:1, beispielsweise von 8:1, umgesetzt werden. Dabei können Urethan- und/oder Allophanatstrukturen gebildet werden. Ein Anteil an nicht umgesetzten Polyisocyanaten kann anschließend abgetrennt werden. Hierfür kann beispielsweise eine Dünnschichtdestillation verwendet, wobei restmonomerenarme Produkte mit Restmonomergehalten von beispielsweise ≤ 1 Gewichtsprozent, bevorzugt ≤ 0,5 Gewichtsprozent, besonders bevorzugt ≤ 0,1 Gewichtsprozent, erhalten werden. Die Reaktionstemperatur kann dabei von 20 °C bis 120 °C, bevorzugt von 60 °C bis 100 °C, betragen. Gegebenenfalls können während der Herstellung Stabilisatoren wie Benzoylchlorid, Isophthaloylchlorid, Dibutylphosphat, 3-Chlorpropionsäure oder Methyltosylat zugesetzt werden.

Weiterhin können NH₂- und/oder NH-funktionelle Komponenten zusätzlich zur Kettenverlängerung bei der Herstellung der Polyisocyanat-Prepolymere B) eingesetzt werden.

Geeignete Komponenten zur Kettenverlängerung sind organische Di- oder Polyamine. Beispielsweise können Ethylendiamin, 1,2- Diaminopropan, 1,3-Diaminopropan, 1,4-Diaminobutan, 1,6-Diaminohexan, Isophorondiamin, Isomerengemisch von 2,2,4- und 2,4,4-Trimethylhexamethylendiamin, 2-Methylpentamethylendiamin, Diethylentriamin, Diaminodicyclohexylmethan oder Dimethylethylendiamin oder Mischungen davon eingesetzt werden.

Darüber hinaus können auch Verbindungen, die neben einer primären Aminogruppe auch sekundäre Aminogruppen oder neben einer Aminogruppe (primär oder sekundär) auch OH-Gruppen aufweisen, zur Herstellung der Polyisocyanat-Prepolymere B) eingesetzt werden. Beispiele hierfür sind primäre/sekundäre Amine, wie Diethanolamin, 3-Amino-1-methylaminopropan, 3-Amino-1-ethylaminopropan, 3-Amino-1-cyclohexylaminopropan, 3-Amino-1-methylaminobutan, Alkanolamine wie N-Aminoethylethanolamin, Ethanolamin, 3-Aminopropanol, Neopentanolamin. Zur Kettenterminierung werden üblicherweise Amine mit einer gegenüber Isocyanaten reaktiven Gruppe wie Methylamin, Ethylamin, Propylamin, Butylamin, Octylamin, Laurylamin, Stearylamin, Isononyloxypropylamin, Dimethylamin, Diethylamin, Dipropylamin, Dibutylamin, N-Methylaminopropylamin, Diethyl(methyl)aminopropylamin, Morpholin, Piperidin, beziehungsweise geeignete substituierte Derivate davon, Amidamine aus diprimären Aminen und Monocarbonsäuren, Monoketim von diprimären Ammen, primär/tertiäre Amine, wie N,N-Dimethylaminopropylamin, verwendet.

Die als Komponente B) eingesetzten Polyisocyanat-Prepolymere oder deren Mischungen können bevorzugt eine mittlere NCO-Funktionalität von 1,8 bis 5, besonders bevorzugt 2 bis 3,5 und ganz besonders bevorzugt 2 bis 2,5 aufweisen.

Die Komponente C) ist eine Verbindung mit mindestens zwei isocyanatreaktiven funktionellen Gruppen. Beispielsweise kann Komponente C) ein Polyamin oder ein Polyol mit mindestens zwei isocyanatreaktiven Hydroxygruppen sein.

Als Komponente C) können hydroxyfunktionelle, insbesondere polymere, Polyole, beispielsweise Polyetherpolyole eingesetzt werden. Beispielsweise eignen sich Polytetramethylenglykolpolyether, wie sie durch Polymerisation von Tetrahydrofuran mittels kationischer Ringöffnung erhältlich sind. Ebenfalls geeignete Polyetherpolyole können die Additionsprodukte von Styroloxid, Ethylenoxid, Propylenoxid, Butylenoxid und/oder Epichlorhydrin an di- oder polyfunktionelle Startermoleküle sein. Als geeignete Startermoleküle können beispielsweise Wasser, Butyldiglykol, Glycerin, Diethylenglykol, Trimethyolpropan, Propylenglykol, Sorbit, Ethylendiamin, Triethanolamin, oder 1,4-Butandiol oder Mischungen davon eingesetzt werden.

Es ist bevorzugt, dass die Komponente C) ein Polymer mit 2 bis 4 Hydroxygruppen pro Molekül, ganz besonders bevorzugt ein Polypropylenglykol mit 2 bis 3 Hydroxygruppen pro Molekül ist. Erfindungsgemäß bevorzugt haben die polymeren Polyole aus C) eine besonders enge Molekulargewichtsverteilung, das heißt eine Polydispersität (PD = Mw/Mn) von 1,0 bis 1,5 und/oder eine OH-Funktionalität von größer 1,9. Bevorzugt weisen die genannten Polyetherpolyole eine Polydispersität von 1,0 bis 1,5 und eine OH-Funktionalität von größer 1,9 auf, besonders bevorzugt größer oder gleich 1,95 auf.

Solche Polyetherpolyole sind in an sich bekannter Weise durch Alkoxylierung von geeigneten Starter-Molekülen, insbesondere unter Verwendung von Doppelmetallcyanid-Katalysatoren (DMC-Katalyse) herstellbar. Diese Methode ist zum Beispiel in der Patentschrift US 5,158,922 und der Offenlegungsschrift EP 0 654 302 A1 beschrieben.

Die Reaktionsmischung für das Polyurethan kann durch Mischen der Komponenten A), B) und C) erhalten werden. Das Verhältnis von isocyanatreaktiven Hydroxygruppen zu freien Isocyanatgruppen ist dabei vorzugsweise von 1:1,5 bis 1,5:1 besonders bevorzugt von 1:1,02:bis 1:0,95.

Vorzugsweise besitzt zumindest eine der Komponenten A), B) oder C) eine Funktionalität von ≥ 2,0, bevorzugt von ≥ 2,5 bevorzugt von ≥ 3,0, um in das Polymerelement eine Verzweigung oder eine Vernetzung einzuführen. Der Begriff "Funktionalität" bezieht sich bei Komponente A) und B) auf die mittlere Anzahl von NCO-Gruppen pro Molekül und bei Komponente C) auf die mittlere Anzahl von OH-Gruppen pro Molekül. Diese Verzeigung beziehungsweise Vernetzung bewirkt bessere mechanische Eigenschaften und bessere elastomere Eigenschaften, insbesondere auch bessere Dehnungseigenschaften

Das Polyurethan kann vorteilhafterweise eine gute mechanische Festigkeit und hohe Elastizität aufweisen. Insbesondere kann das Polyurethan eine maximale Spannung von ≥ 0,2 MPa, insbesondere von 0,4 MPa bis 50 MPa, und eine maximale Dehnung von ≥ 250 %, insbesondere von ≥ 350 %, aufweisen. Darüber hinaus kann das Polyurethan im Gebrauchsdehnungsbereich von 50 % bis 200 % eine Spannung von 0,1 MPa bis 1 MPa, beispielsweise von 0,1 MPa bis 0,8MPa, insbesondere von 0,1 MPa bis 0,3 MPa, aufweisen (Bestimmung nach DIN 53504). Ferner kann das Polyurethan ein Elastizitätsmodul bei einer Dehnung von 100 % von 0,1 MPa bis 10 MPa, beispielsweise von 0,2 MPa bis 5 MPa, aufweisen (Bestimmung nach DIN EN 150 672 1-1).

Das Polyurethan kann weiterhin vorteilhafterweise gute elektrische Eigenschaften aufweisen; diese können für die Durchbruchsfeldstärke nach ASTM D 149 und für die Messungen der Dielektrizitätskonstante ASTM D 150 bestimmt werden.

Die Reaktionsmischung kann neben den Komponenten A), B) und C) zusätzlich auch Hilfs- und Zusatzstoffe enthalten. Beispiele für solche Hilfs- und Zusatzstoffe sind Vernetzer, Verdicker, Colösemittel, Thixotropiermittel, Stabilisatoren, Antioxidantien, Lichtschutzmittel, Emulgatoren, Tenside, Klebstoffe, Weichmacher, Hydrophobierungsmittel, Pigmente, Füllstoffe und Verlaufshilfsmittel.

Füllstoffe können beispielsweise die Dielektrizitätskonstante des Polymerelements regulieren. Vorzugsweise umfasst die Reaktionsmischung Füllstoffe zur Erhöhung der Dielektrizitätskonstanten wie Füllstoffe mit einer hohen Dielektrizitätskonstante. Beispiele hierfür sind keramische Füllstoffe, insbesondere Bariumtitanat, Titandioxid und piezoelektrische Keramiken wie Quarz oder Bleizirkoniumtitanat, sowie organische Füllstoffe, insbesondere solche mit einer hohen elektrischen Polarisierbarkeit, beispielsweise Phthalocyanine.

Außerdem ist eine hohe Dielektrizitätskonstante auch durch das Einbringen elektrisch leitfähiger Füllstoffe unterhalb der Perkolationsschwelle erzielbar. Beispiele hierfür sind Ruß, Graphit, einwandige oder mehrwandige Kohlenstoff-Nanoröhrchen, elektrisch leitfähige Polymere wie Polythiophene, Polyaniline oder Polypyrrole, oder Mischungen davon. In diesem Zusammenhang sind insbesondere solche Rußtypen von Interesse, die eine Oberflächenpassivierung aufweisen und deshalb bei niedrigen Konzentrationen unterhalb der Perkolationsschwelle zwar die Dielektrizitätskonstante erhöhen und trotzdem nicht zu einer Erhöhung der Leitfähigkeit des Polymers führen.

Angemerkt sei, dass die Begriffe "ein" und "eine" im Zusammenhang mit der vorliegenden Erfindung und insbesondere mit den Komponenten A), B) und C) nicht als Zahlwörter, sondern als unbestimmter Artikel verwendet werden, sofern der Kontext nicht eindeutig eine andere Aussage ergibt.

In einer Ausführungsform des erfindungsgemäßen Polymerschichtverbundes ist der monomere, monofunktionelle aromatische Alkohol ein in 3- und/oder 4-Position substituiertes 2-Hydroxymethylthiophen der allgemeinen Formel (II): 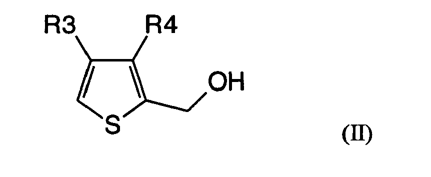 wobei gilt: R3 und R4 sind unabhängig voneinander Wasserstoff, Alkyl, Aryl, Alkoxy, Aryloxy oder aber R3 und R4 bilden gemeinsam eine unsubstituierte oder substituierte Alkylendioxy-Gruppe.

Beispiele für unsubstituierte Alkylendioxy-Gruppen -O-[CH₂]ₙ-O- sind Methylendioxy (-O-[CH₂]-O-), Ethylendioxy (-O-[CH₂]₂-O-), Propylendioxy (-O-[CH₂]₃-O-) und Butylendioxy (-O-[CH₂]₄-O-). In substituierten Alkylendioxy-Gruppen befinden sich an den [CH₂]ₙ-Gruppen weitere Substituenten. Beispielsweise kann jedes Kohlenstoffatom einer Ethylendioxy-Gruppe einen Methylsubstituenten tragen (-O-[CH(CH₃)₂]₂-O-). Weitere Substituenten für Alkylendioxygruppen können unter anderem Hydroxy- und Hydroxymethylgruppen sein.

In einer weiteren Ausführungsform des erfindungsgemäßen Polymerschichtverbundes bilden R3 und R4 gemeinsam eine Ethylendioxy-Gruppe. Dann wird als substituiertes Thiophen (II) 2-Hydroxymethyl-3,4-ethylendioxythiophen eingesetzt, wie in Formel (IIa) dargestellt:

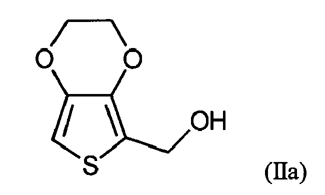

In einer weiteren Ausführungsform des erfindungsgemäßen Polymerschichtverbundes umfasst die zweite Schicht Polystyrolsulfonat und Poly(3,4-ethylendioxythiophen). Diese Mischung ist kommerziell unter der Bezeichnung "PSS:PEDOT" erhältlich.

In einer weiteren Ausführungsform des erfindungsgemäßen Polymerschichtverbundes liegt das molare Verhältnis zwischen der difunktionellen, gegenüber Isocyanatgruppen reaktiven Verbindung C) und dem monomeren, monofunktionellen Alkohol in einem Bereich von ≥ 50:100 bis ≤ 100:50. Vorzugsweise liegt ein leichter molarer Überschuss des monomeren Alkohols vor. Beispielsweise kann das Verhältnis in einem Bereich von ≥ 100:80 bis ≤ 100:90 liegen.

In einer weiteren Ausführungsform des erfindungsgemäßen Schichtenverbundes wird die erste Schicht auf gegenüberliegenden Seiten von jeweils der zweiten Schicht entsprechenden Schichten kontaktiert. Auf diese Weise lässt sich eine beidseitig mit Elektroden kontaktierte Elastomerschicht erhalten.

Die vorliegende Erfindung betrifft weiterhin ein Verfahren zur Herstellung eines erfindungsgemäßen Polymerschichtenverbundes, umfassend die Schritte:
Bereitstellen eines Polyurethanpolymers, welches erhältlich ist aus der Reaktion eines Polyisocyanats A) und/oder eines Polyisocyanat-Prepolymers B) mit einer mindestens difunktionellen, gegenüber Isocyanatgruppen reaktiven Verbindung C) sowie weiterhin eines monomeren, monofunktionellen aromatischen Alkohols; und
zumindest teilweises Kontaktieren des Polyurethanpolymers mit einer Mischung, welche polymeres in 3- und/oder 4-Position substituiertes Thiophen der allgemeinen Formel (III): 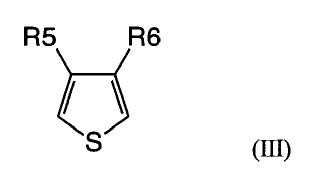 wobei gilt: R5 und R6 sind unabhängig voneinander Wasserstoff, Alkyl, Aryl, Alkoxy, Aryloxy oder aber R5 und R6 bilden gemeinsam eine unsubstituierte oder substituierte Alkylendioxy-Gruppe
und Polystyrolsulfonat umfasst.

In einer Ausführungsform des erfindungsgemäßen Verfahrens ist der monomere, monofunktionelle aromatische Alkohol ein in 3- und/oder 4-Position substituiertes 2-Hydroxymethylthiophen der allgemeinen Formel (IV): 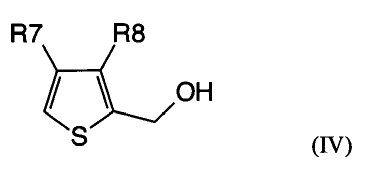 wobei gilt: R7 und R8 sind unabhängig voneinander Wasserstoff, Alkyl, Aryl, Alkoxy, Aryloxy oder aber R7 und R8 bilden gemeinsam eine unsubstituierte oder substituierte Alkylendioxy-Gruppe.

Vorzugsweise bilden im erfindungsgemäßen Verfahren R7 und R8 gemeinsam eine Ethylendioxygruppe. Dann wird als substituiertes Thiophen (IV) 2-Hydroxymethyl-3,4-ethylendioxythiophen eingesetzt. Es ist ebenfalls bevorzugt, dass das polymere Thiophen (III) Poly(3,4-ethylendioxythiophen) ist. Dessen Mischung mit Polystyrolsulfonat ist kommerziell unter der Bezeichnung "PSS:PEDOT" erhältlich.

In einer weiteren Ausführungsform des erfindungsgemäßen Verfahrens liegt die Mischung, welche Polystyrolsulfonat und polymeres in 3- und/oder 4-Position substituiertes Thiophen der allgemeinen Formel (III) umfasst, in Form einer wässrigen Dispersion vor.

Ein weiterer Gegenstand der vorliegenden Erfindung ist die Verwendung eines erfindungsgemäßen Polymerschichtenverbundes als dehnbare Elektrode. Solch eine dehnbare Elektrode kann beispielsweise in einem elektromechanischen Wandler eingesetzt werden. Vorzugsweise ist die dehnbare Elektrode so aufgebaut, dass die erste, Polyurethanpolymer umfassende Schicht, beidseitig zumindest teilweise kontaktiert wird von elektrisch nicht miteinander verbundenen, den zuvor beschriebenen zweiten Schichten entsprechenden Schichten.

Details zu dem Polymerschichtenverbund einschließlich der Ausführungsformen wurden bereits vorstehend beschrieben. Zur Vermeidung von unnötigen Wiederholungen wird bezüglich dessen Verwendung hierauf Bezug genommen.

Die vorliegende Erfindung betrifft weiterhin einen elektromechanischen Wandler, umfassend einen erfindungsgemäßen Polymerschichtenverbund. Vorzugsweise ist der Polymerschichtenverbund im elektromechanischen Wandler so aufgebaut, dass die erste, Polyurethanpolymer umfassende Schicht, beidseitig zumindest teilweise kontaktiert wird von elektrisch nicht miteinander verbundenen, den zuvor beschriebenen zweiten Schichten entsprechenden Schichten. Dann kann der erfindungsgemäße Schichtenverbund als beidseitig kontaktiertes dielektrisches Elastomer fungieren.

Wenn eine mechanische Beanspruchung auf einen derartigen Wandler ausgeübt wird, so deformiert sich der Wandler beispielsweise entlang seiner Dicke und seiner Fläche und ein starkes elektrisches Signal kann an den Elektroden detektiert werden. Damit wird mechanische Energie in elektrische Energie umgewandelt. Der erfindungsgemäße Wandler kann folglich sowohl als Generator als auch als Sensor eingesetzt werden.

Unter Ausnutzung des entgegengesetzten Effekts, nämlich der Umwandlung von elektrischer Energie in mechanische Energie, kann der erfindungsgemäße Wandler andererseits gleichermaßen als Aktuator dienen.

Einsatzmöglichkeiten eines solchen elektromechanischen Wandlers finden sich in einer Vielzahl von verschiedensten Anwendungen im elektromechanischen und elektroakustischen Bereich, insbesondere im Bereich der Energiegewinnung aus mechanischen Schwingungen ("Energy Harvesting"), der Akustik, des Ultraschalls, der medizinischen Diagnostik, der akustischen Mikroskopie, der mechanischen Sensorik, insbesondere Druck- Kraft- und/oder Dehnungssensorik, der Robotik und/oder der Kommunikationstechnologie. Typische Beispiele hierfür sind Drucksensoren, elektroakustische Wandler, Mikrophone, Lautsprecher, Schwingungswandler, Lichtdeflektoren, Membrane, Modulatoren für Glasfaseroptik, pyroelektrische Detektoren, Kondensatoren und Kontrollsysteme und "intelligente" Fußböden sowie Systeme zur Umwandlung von Wasserwellenenergie, insbesondere Meereswellenenergie, in elektrische Energie.

Dielektrische Elastomere im Sinne der vorliegenden Erfindung sind Elastomere, die ihre Form durch das Anlegen eines elektrischen Feldes ändern können. Im Fall von Elastomerfolien kann sich zum Beispiel die Dicke verringern, während es gleichzeitig zu einer Längenausdehnung der Folie in Flächenrichtung kommt.

Die Dicke der dielektrischen Elastomerschicht beträgt vorzugsweise ≥ 1 µm bis ≤ 500 µm und mehr bevorzugt ≥ 10 µm bis ≤ 100 µm. Sie kann einstückig oder mehrstückig aufgebaut sein. Beispielsweise kann eine mehrstückige Schicht durch Aufeinanderlaminieren von einzelnen Schichten erhalten werden.

Das dielektrische Elastomer kann neben dem erfindungsgemäß vorgesehenen Polyurethanpolymer noch weitere Inhaltsstoffe aufweisen. Solche Inhaltsstoffe sind beispielsweise Vernetzer, Verdicker, Colösemittel, Thixotropiermittel, Stabilisatoren, Antioxidantien, Lichtschutzmittel, Emulgatoren, Tenside, Klebstoffe, Weichmacher, Hydrophobierungsmittel, Pigmente, Füllstoffe und Verlaufshilfsmittel.

Füllstoffe im Elastomer können beispielsweise die Dielektrizitätskonstante des Polymers regulieren. Beispiele hierfür sind keramische Füllstoffe, insbesondere Bariumtitanat, Titandioxid und piezoelektrische Keramiken wie Quarz oder Bleizirkoniumtitanat, sowie organische Füllstoffe, insbesondere solche mit einer hohen elektrischen Polarisierbarkeit, beispielsweise Phthalocyanine.

Außerdem ist eine hohe Dielektrizitätskonstante auch durch das Einbringen elektrisch leitfähiger Füllstoffe unterhalb ihrer Perkolationsschwelle erzielbar. Beispiele hierfür sind Ruß, Graphit, einwandige oder mehrwandige Kohlenstoff-Nanoröhrehen, elektrisch leitfähige Polymere wie Polythiophene, Polyaniline oder Polypyrrole, oder Mischungen davon. In diesem Zusammenhang sind insbesondere solche Rußtypen von Interesse, die eine Oberflächenpassivierung aufweisen und deshalb bei niedrigen Konzentrationen unterhalb der Perkolationsschwelle zwar die Dielektrizitätskonstante erhöhen und trotzdem nicht zu einer Erhöhung der Leitfähigkeit des Polymers führen.

Details zu dem Polymerschichtenverbund einschließlich der Ausführungsformen wurden bereits vorstehend beschrieben. Zur Vermeidung von unnötigen Wiederholungen wird bezüglich dessen Einsatz in einem elektromechanischen Wandler hierauf Bezug genommen.

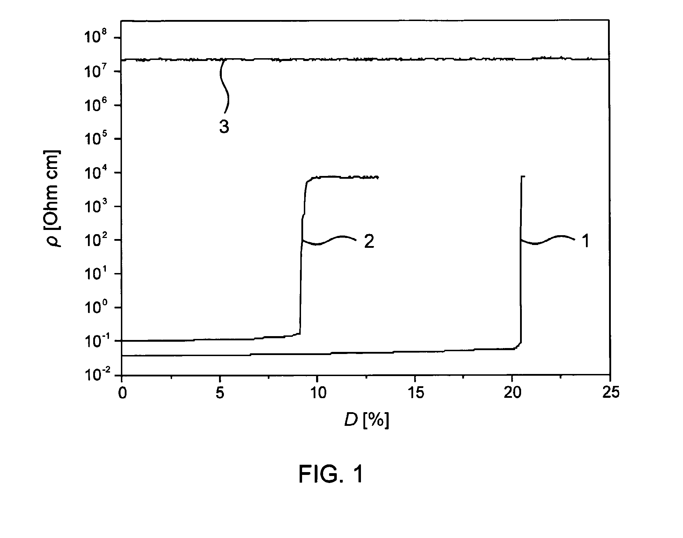

Die Erfindung wird anhand der nachfolgenden Beispiele in Verbindung mit der Figur 1 weiter erläutert, ohne jedoch darauf beschränkt zu sein.

Lösungsmittel wurden von Merck, Fluka, Lancaster and Aldrich bezogen, über den üblichen Trockenmitteln getrocknet und redestilliert. 3,4-Ethylendioxythiophen wurde von Sigma-Aldrich bezogen und Phosphoroxychlorid von ACROS Organics (99%).

Die Synthese von 2-Hydroxymethyl-3,4-ethylendioxythiophen erfolgte durch Reduktion des entsprechenden Aldehyden (2-Formyl-3,4-ethylendioxythiophen) mit Natriumborhydrid.

### Beispiel 1: Synthese von 2-Formyl-3,4-ethylendioxythiophen:

In einem 100 mL Dreihalskolben wurden unter Schutzgas 10,00 g (70,35 mmol) 3,4-Ethylendioxythiophen und 0,68 g (77,76 mmol, 1,1 eq) trockenes N,N-Dimethylformamid in 15 mL trockenem Dichlormethan gelöst, Bei 0 °C wurden tropfenweise 11,92 g (77,76 mmol, 1,1 eq) Phosphorylchlorid zugegeben und 10 min weitergerührt. Anschließend wurde das Reaktionsgemisch zwei Stunden unter Rückfluss erhitzt. Im Verlauf der Reaktion färbte sich das Reaktionsgemisch langsam rot. Nach beendeter Reaktion wurde das Reaktionsgemisch in 400 mL eisgekühltes Wasser gegeben und eine Stunde gerührt. Im Scheidetrichter wurden wässrige und organische Phase getrennt. Aus der wässrigen Phase fielen nach einiger Zeit farblose bis rosafarbene Nadeln aus. Umkristallisieren aus Dichlormethan lieferte 10,93 g (63,48 mmol, 90%) 2-Formyl-3,4-ethylendioxythiophen als farblosen Feststoff. 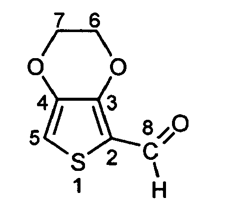 Schmelzpunkt: 146,0 °C.
IR (cm¹): ν̃ = 3108 (w) (ν_{=C-H}); 2842 (w) (ν_{C-H}, aliph.); 1646 (s) (ν_{C=O}, _{CHO}); 1487 (m) 1438 (s) (ν_{C=C} Thiophen); 1383 (s), 1364 (s) (δ_{C-H}); 1259 (m), 1237 (m), 1174 (m), 1135 (m) (δ_{C-H Thiophen}); 1063 (m), 1010 (m) (ν_{C-O-C}); 961 (m), 908 (m), 847 (w), 762 (s) (δ_{C-H} Thiophen).
¹H-NMR (250.13 MHz, d¹-CHCl₃): δ [ppm] = 9.88 (s, 1H, H-8), 6.78 (s, 1H, H-5), 4.374.24 (m, 4H, H-6, H-7).
¹³C-NMR (62.90 MHz, d¹-CHCl₃): δ [ppm] = 180.2 (C-8), 148.6 (C-4), 141.9 (C-3), 118.6 (C-2), 110.8 (C-5), 65.4, 64.5 (C-6, C-7).
C₇H₆O₃S (170.19 gmol⁻¹). Elementaranalyse: berechnet: C 49.40, H 3.55, S 18.84; gefunden: C 49.43, H 3.59, S 19.20

### Beispiel 2: Synthese von 2-Hydroxymethyl-3,4-ethylendioxythiophen

In einem 1000 mL Dreihalskolben wurden unter Schutzgas 11,60 g (68,18 mmol) 2-Formyl-3,4-ethylendioxythiophen in 200 ml trockenem Dichlormethan gelöst und auf 0 °C abgekühlt. 7,74 g (204.5 mmol, 3.0 eq) NaBH₄ wurden in 200 mL trockenem Methanol gelöst und über einen Tropftrichter langsam zum Reaktionsgemisch zugetropft. Die Reaktionslösung wurde über Nacht bei Raumtemperatur gerührt. Anschließend wurde mit 800 ml NaOH-Lösung hydrolysiert und 1h weitergerührt. Die organische Phase wurde mit dest. Wasser gewaschen und bis zur Trockne am Rotationsverdampfer eingeengt. Es wurde ein rosafarbenes Öl erhalten, welches nach einiger Zeit auskristallisierte. Es wurden 10,93 g (63,48 mmol, 92%) 2-Hydroxymethyl-3,4-ethylendioxythiophen als leicht rosa-farbener Feststoffe erhalten. 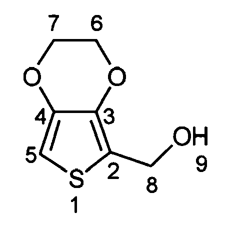 Schmelzpunkt: 68,6 °C.

IR(cm¹): ν̃ = 3368 (m), 3296 (m) (ν_{O-H}); 3126 (w) (ν_{C-H arom}); 2920 (w), 2867 (w) (ν_{C-H, aliph}.); 1494 (s) 1441 (s) (ν_{C=C Thiophen}); 1370 (m), 1339 (m) (δ_{C-H aliph}); 1243 (m), 1212 (m), 1160 (m), (δ_{C-H Thiophen}); 1083 (m), 1040 (s) (ν_{C-O-C}); 972 (m), 930 (m), 892 (m) (δ_{C-H Thiophen}).
¹H-NMR (250.13 MHz, d¹-CHCl₃): δ [ppm] = 6.28 (s, 1H, H-5), 4.67 (d, 2H, H-8), 4.244.18 (m, 4H, H-6, H-7); 1.74 (t, 1H, H-9).
¹³C-NMR (62.90 MHz, d¹-CHCl₃): δ [ppm] = 141.5 (C-4), 138.9 (C-3), 116.2 (C-2), 98.5 (C-5), 64.8, 64.6 (C-6, C-7), 55.97 (C-8).
C₇H₈O₃S (172.19 gmol⁻¹). Elementaranalyse: berechnet: C 48.82, H 4.68, S 18.62; gefunden: C 48.83, H 4.63, S 18.95.

### Beispiel 3:

2,134 g 2-Hydroxymethyl-3,4-ethylendixoxythiophen (Mw: 172,17 g/mol) wurden in 42,68 g eines mittels DMC-Verfahren hergestellten Polyetherpolyols des Molgewichtes 4000, der Funktionalität 2 und einem Ethylenoxidanteil von 15% gelöst. Dieses entsprach einem Molverhältnis von Thiophen zu Polyol von 100:86. Anschließend wurden 0,256 g des Katalysators Dibutylzinndilaurat (DBTL) unter Rühren hinzugefügt. Die zweite Polyurethankomponente, 14 g eines HDI-Trimers (Desmodur® N 3300, Bayer MaterialScience AG), wurde hinzugegeben und die Mischung wurde in einem Speedmixer gerührt. Nach dem homogenen Vermischen der Komponenten wurden diese auf ein PET-Substrat aufgerakelt. Die Nassschichtdicke betrug 500 µm. Anschließend wurden die beschichteten Substrate in einem auf 100 °C vorgeheizten Ofen für 20 Minuten gelagert und man ließ auf Raumtemperatur abkühlen. Eine kommerziell erhältliche PSS:PEDOT-Suspension (Agfa® Orgacon® 6010) wurde in einer Nassschichtdicke von 500 µm aufgerakelt und es wurde für 10 Minuten bei 80 °C im Ofen getrocknet.

FIG. 1 zeigt eine Auftragung des spezifischen elektrischen Widerstands p, berechnet aus dem Widerstand der Elektrode zwischen den Klemmen der Zugmaschine (DIN 53504) und der Geometrie der Elektrode mit einer Länge von 30 mm, einer Breite von 10 mm und einer Dicke von 4,14 µm gegen die Dehnung D für einen gemäß dem Beispiel 3 erhaltenen Schichtenverbund (Kurve 1), für einen Polyurethanfilm analog zu dem Beispiel 3, aber ohne das Thiophen des Beispiels und mit PSS:PEDOT-Beschichtung (Kurve 2) sowie für einen Polyurethanfilm analog zu dem Beispiel 3, in dessen Herstellung jedoch kein 2-Hydroxymethyl-3,4-ethylendixoxythiophen eingesetzt wurde und der nicht mit PSS:PEDOT beschichtet war (Kurve 3). Der spezifische Widerstand wurde, wo angebracht, von der PSS:PEDOT-Schicht ermittelt.

Man erkennt zunächst, dass der in Kurve 3 behandelte Film einen sehr hohen spezifischen elektrischen Widerstand unabhängig vom Grad der Dehnung des Films zeigt. Dieses entspricht auch den Erwartungen. Ein Vergleich der Kurven 1 und 2 zeigt, dass der erfindungsgemäße Schichtenverbund (Kurve 1) seinen in diesem Zusammenhang niedrigen spezifischen Widerstand bis zu einer deutlich höheren Dehnung beibehält als ein Schichtenverbund ohne 2-Hydroxymethyl-3,4-ethylendixoxythiophen in der Herstellung des Polyurethans (Kurve 2). Dieses ist konsistent mit einer besseren Haftung der PSS:PEDOT-Schicht im erfindungsgemäßen Schichtenverbund.

## Patentansprüche

1. Polymerschichtenverbund, umfassend eine erste Schicht und eine die erste Schicht zumindest teilweise kontaktierende zweite Schicht, **dadurch gekennzeichnet, dass**
die erste Schicht ein Polyurethanpolymer umfasst, welches erhältlich ist aus der Reaktion eines Polyisocyanats A) und/oder eines Polyisocyanat-Prepolymers B) mit einer mindestens difunktionellen, gegenüber Isocyanatgruppen reaktiven Verbindung C) sowie weiterhin eines monomeren, monofunktionellen aromatischen Alkohols; und
die zweite Schicht polymeres in 3- und/oder 4-Position substituiertes Thiophen der allgemeinen Formel (I): 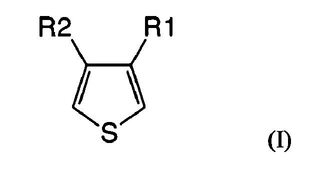 wobei gilt: R1 und R2 sind unabhängig voneinander Wasserstoff, Alkyl, Aryl, Alkoxy, Aryloxy oder aber R1 und R2 bilden gemeinsam eine unsubstituierte oder substituierte Alkylendioxy-Gruppe
und Polystyrolsulfonat umfasst.

2. Polymerschichtenverbund gemäß Anspruch 1, wobei der monomere, monofunktionelle aromatische Alkohol ein in 3- und/oder 4-Position substituiertes 2-Hydroxymethylthiophen der allgemeinen Formel (II) ist: 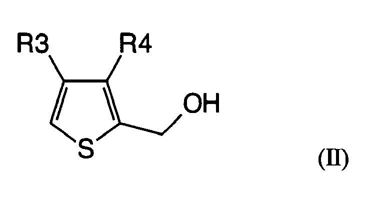 wobei gilt: R3 und R4 sind unabhängig voneinander Wasserstoff, Alkyl, Aryl, Alkoxy, Aryloxy oder aber R3 und R4 bilden gemeinsam eine unsubstituierte oder substituierte Alkylendioxy-Gruppe.

3. Polymerschichtverbund gemäß Anspruch 2, wobei R3 und R4 gemeinsam eine Ethylendioxy-Gruppe bilden.

4. Polymerschichtverbund gemäß Anspruch 1, wobei die zweite Schicht Polystyrolsulfonat und Poly(3,4-ethylendioxythiophen) umfasst.

5. Polymerschichtenverbund gemäß Anspruch 1, wobei das molare Verhältnis zwischen der difunktionellen, gegenüber Isocyanatgruppen reaktiven Verbindung C) und dem monomeren, monofunktionellen Alkohol in einem Bereich von ≥ 50:100 bis ≤ 100:50 liegt.

6. Polymerschichtenverbund gemäß Anspruch 1, wobei die erste Schicht auf gegenüberliegenden Seiten von jeweils der zweiten Schicht entsprechenden Schichten kontaktiert wird.

7. Verfahren zur Herstellung eines Polymerschichtenverbundes gemäß Anspruch 1, umfassend die Schritte:
Bereitstellen eines Polyurethanpolymers, welches erhältlich ist aus der Reaktion eines Polyisocyanats A) und/oder eines Polyisocyanat-Prepolymers B) mit einer mindestens difunktionellen, gegenüber Isocyanatgruppen reaktiven Verbindung C) sowie weiterhin eines monomeren, monofunktionellen aromatischen Alkohols; und
zumindest teilweises Kontaktieren des Polyurethanpolymers mit einer Mischung, welche polymeres in 3- und/oder 4-Position substituiertes Thiophen der allgemeinen Formel (III): 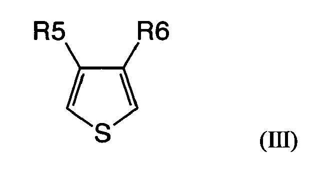 wobei gilt: R5 und R6 sind unabhängig voneinander Wasserstoff, Alkyl, Aryl, Alkoxy, Aryloxy oder aber R5 und R6 bilden gemeinsam eine unsubstituierte oder substituierte Alkylendioxy-Gruppe
und Polystyrolsulfonat umfasst.

8. Verfahren gemäß Anspruch 7, wobei der monomere, monofunktionelle aromatische Alkohol ein in 3- und/oder 4-Position substituiertes 2-Hydroxymethylthiophen der allgemeinen Formel (IV) ist: 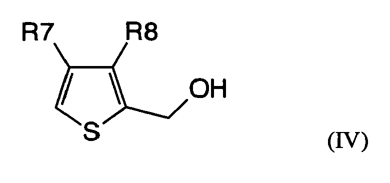 wobei gilt: R7 und R8 sind unabhängig voneinander Wasserstoff, Alkyl, Aryl, Alkoxy, Aryloxy oder aber R7 und R8 bilden gemeinsam eine unsubstituierte oder substituierte Alkylendioxy-Gruppe.

9. Verfahren gemäß Anspruch 8, wobei die Mischung, welche Polystyrolsulfonat und polymeres in 3- und/oder 4-Position substituiertes Thiophen der allgemeinen Formel (III) umfasst, in Form einer wässrigen Dispersion vorliegt.

10. Verfahren gemäß Anspruch 8, wobei das molare Verhältnis zwischen der difunktionellen, gegenüber Isocyanatgruppen reaktiven Verbindung C) und dem monomeren, monofunktionellen Alkohol in einem Bereich von ≥ 50:100 bis ≤ 100:50 liegt.

11. Verwendung eines Polymerschichtenverbundes gemäß Anspruch 1 als dehnbare Elektrode.

12. Elektromechanischer Wandler, umfassend einen Polymerschichtenverbund gemäß Anspruch 1.
